# EUROPEAN PATENT SPECIFICATION

(11) **EP 2 975 635 B1**
(45) Date of publication and mention of the grant of the patent: **29.07.2020**
(21) Application number: 15154221.4
(22) Date of filing: 06.02.2015
(51) Int. Cl.: C23C 16/04, C23C 16/24, C23C 16/56, H01L 21/3205, H01L 21/768

(54) **Process for forming silicon-filled openings with a reduced occurrence of voids**
Verfahren zur Herstellung von mit Silizium gefüllten Öffnungen mit reduziertem Auftreten von Hohlräumen
Procédé pour former des ouvertures remplies de silicium avec une occurrence réduite de vides

(30) Priority: 18.07.2014 US 201414335446; 26.11.2014 US 201414555379
(43) Date of publication of application: 20.01.2016
(73) Proprietor: ASM IP Holding B.V., 1322 AP Almere (NL)
(72) Inventor: Van Aerde, Steven R. A., 1322 AP Almere (NL); Oosterlaken, Theodorus G.M., 1322 AP Almere (NL); Van Der Jeugd, Cornelius A., 1322 AP Almere (NL)
(74) Representative: f & e patent

(56) References cited:
- US-A- 5 326 722
- US-A- 5 525 540
- US-A- 6 067 680
- US-A1- 2007 026 651
- US-A1- 2013 005 142

## Description

### FIELD

This disclosure relates to semiconductor processing and, in particular, to forming silicon-filled openings having no or a low occurrence of voids in the silicon fill.

### BACKGROUND

Semiconductor devices typically include openings that have been filled with polysilicon, which may form constituent parts of various electronic devices. The fill may include depositing a layer of silicon on side and bottom surfaces of the opening, with the layer filling in the opening from the sides and bottom as it grows. The growth of the layer may not be completely uniform, however, causing voids, such as seams, to form in the interior of the opening. In some cases, these voids may be caused by the deposition process, in which silicon may deposit at a higher rate at the top of the opening than at the bottom, thereby causing the top of the opening to close up first, leaving the voids in the interior of the opening.

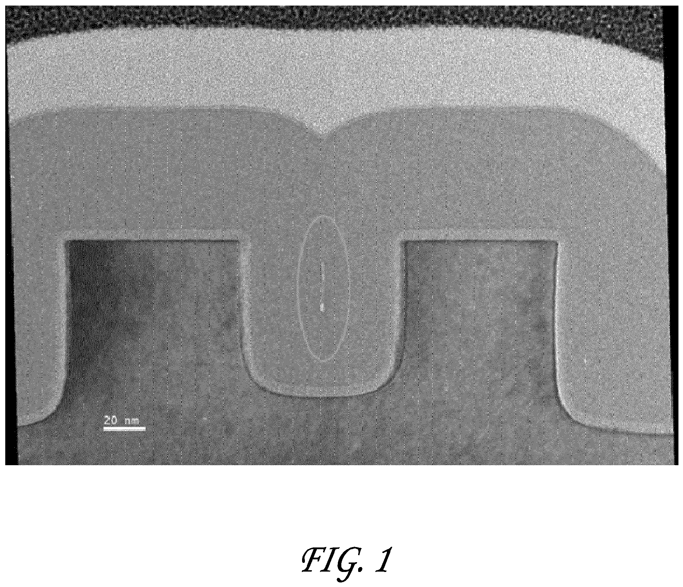

Figure 1 shows a transmission electron micrograph (TEM) cross-section of an opening filled with an as-deposited, amorphous silicon film. As seen in the circled region at the center of the cross-section, a void, a vertically-elongated seam in this case, is present. Such voids can adversely impact the electronic devices formed by the filled opening. Accordingly, there is a need for processes for forming silicon-filled openings, while leaving no or nearly no voids in the openings.

US 5 326 722 discloses a method comprising forming an amorphous silicon film in a trench, forming a thin native silicon oxide film on the amorphous silicon film and annealing to crystallize the film. The method removes silicon oxide islands within the interface between the resulting polysilicon contact layer and a buried contact.

US 6 067 680 discloses a method comprising forming amorphous silicon in a trench, exposing the a-Si to an n-type dopant gas and annealing to crystallize the amorphous silicon film.

### SUMMARY

The invention relates to a method as defined in claim 1. The method includes depositing an amorphous silicon film onto a substrate at a deposition temperature in a deposition chamber. The substrate has a trench and the amorphous silicon film is deposited to a thickness sufficient to fill the trench. The deposited amorphous silicon film is exposed to an oxidizing gas, a nitriding gas, or an n-type dopant gas at a temperature of about 575 °C or below. The substrate is subsequently heated to an anneal temperature. The substrate is then maintained at the anneal temperature to crystallize the amorphous silicon film in the trench. This anneal may convert the amorphous silicon film to a polysilicon film.

In some embodiments, the deposition temperature is about 550°C or below. The anneal temperature may be about 580°C or higher. The substrate may be maintained at the anneal temperatures for about 30 minutes or more. In some embodiments, exposing the substrate to the n-type dopant gas comprises exposing the substrate to a phosphorus-containing gas, an arsenic-containing gas, or an antimony-containing gas.

In some other embodiments, a method for semiconductor processing is provided. The method includes depositing a silicon film on a substrate and into an opening in the substrate, thereby filling the opening. Portions of the silicon film in the opening comprises a void. The method further includes exposing a surface of the amorphous silicon film to a silicon mobility inhibitor and subsequently reducing a size of the void by annealing the silicon film.

### BRIEF DESCRIPTION OF THE DRAWINGS

Figure 1 shows a transmission electron micrograph (TEM) cross-section of an opening filled with an as-deposited, amorphous silicon film.
Figure 2 shows a TEM cross-section of an as-deposited, amorphous silicon film after being annealed at 600°C.
Figure 3 shows a scanning electron micrograph (SEM) of an as-deposited, amorphous silicon film annealed at 600°C.
Figure 4 is a flowchart illustrating a method of reducing voids or seams in the silicon-filled opening.
Figures 5A, 5B, and 5C show, respectively, TEM cross-sections of openings filled with an amorphous silicon film, after being exposed to oxygen and annealed at atmospheric pressure at A) 600°C, for 240 minutes; B) 700°C, for 120 minutes; and C) 800°C, for 60 minutes.
Figure 6 shows a TEM cross-section of an opening filled with an amorphous silicon film, after being exposed to oxygen and annealed at 500 mTorr and 600°C for 240 minutes.

### DETAILED DESCRIPTION

One proposed approach for eliminating voids in openings filled with silicon is to perform an anneal after depositing the silicon into the openings. As used herein, the silicon in the openings may also be referred to as a silicon fill. It has been contemplated that the anneal would cause a crystallization of the silicon, along with a rearrangement or movement of the silicon atoms, thereby causing the voids or seams to disappear or be "healed."

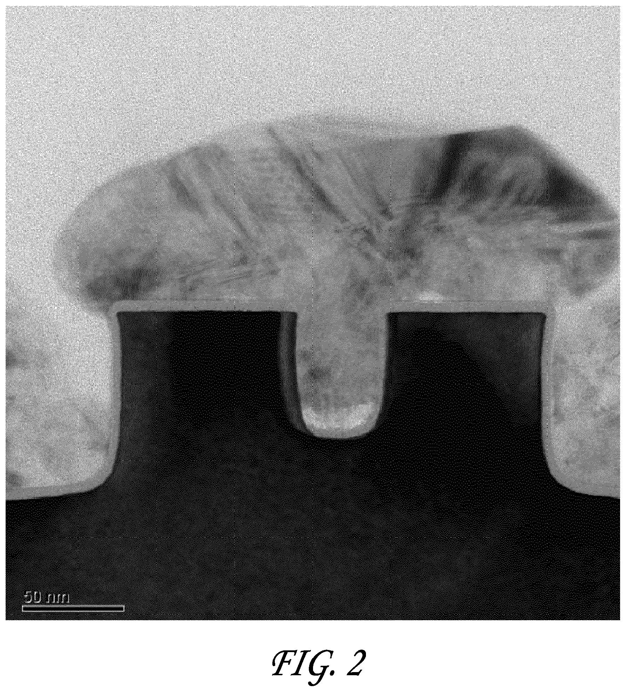

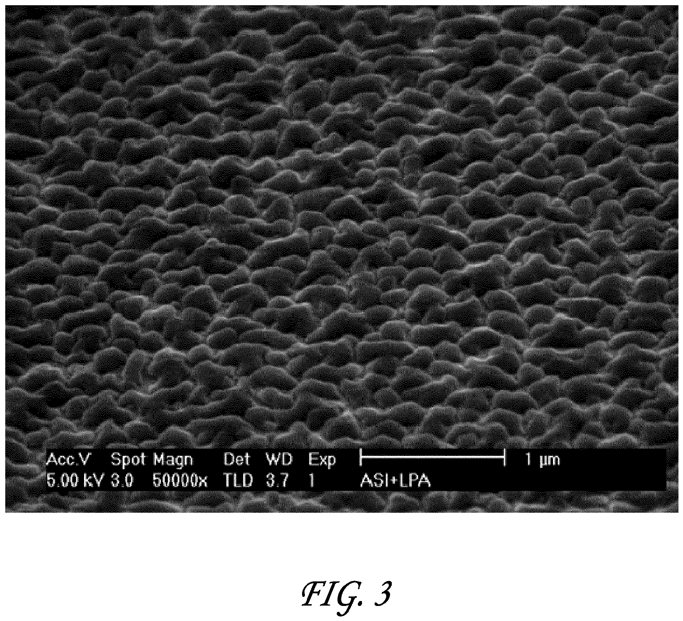

It has been found, however, that such an anneal produced other undesirable changes in the deposited silicon. For example, the anneal was found to cause extreme roughening of the deposited silicon. Examples of such roughening are shown in Figures 2 and 3. Figure 2 shows a TEM cross-section of an as-deposited, amorphous silicon film after being annealed at 600°C. Figure 3 shows a scanning electron micrograph (SEM) of an as-deposited, amorphous silicon film annealed at 600°C. The amorphous silicon film was deposited in a trench which was elongated in a direction extending out of the page. Although the void seems to have been eliminated in the narrowest trench, the amount of atom rearrangement and the resulting surface roughness was large. The resulting film was unsuitable for use in integrated circuit structures. Indeed, at some spots, the film completely disappeared after the anneal.

In some embodiments, silicon-filled openings are formed having no or exceptionally small voids in the silicon fill, while maintaining a smooth exposed silicon surface. In some embodiments, an opening in a substrate may be filled with silicon, which may be amorphous silicon. In some embodiments, the silicon fill may include a plurality of deposited layers (e.g., including a doped silicon layer), with a final, top layer of amorphous silicon completing the fill of the opening. The silicon in the openings has voids, such as seams, which may be, e.g., near the center of the openings. Consequently, the voids may be closed volumes in the interior of the opening. The silicon fill is exposed to a silicon mobility inhibitor and is subsequently annealed. Advantageously, after the anneal, the voids may be reduced in size and, in some embodiments, this reduction in size may occur to such an extent that the voids are eliminated. Additionally, the anneal may crystallize amorphous silicon by converting the amorphous silicon to a more crystalline form of silicon, e.g., to polysilicon. In some embodiments, the anneal may convert the amorphous silicon fill to a polysilicon fill.

Without being limited by theory, the silicon mobility inhibitor is believed to interact with exposed silicon to limit the movement of silicon atoms. Advantageously, the natural pinching behavior in some depositions, which can cause the formation of voids, also prevents or limits the movement of the mobility inhibitor into the voids. As a result, silicon atoms in the interiors of the filled openings are relatively free to move and to rearrange during an anneal, while the silicon atoms on the exposed surface are limited in their movements by the exposure to the mobility inhibitor. Advantageously, this difference in movement of silicon atoms allows the voids to be eliminated or reduced without roughening the exposed surface. Thus, the exposed surface remains substantially as smooth as it was immediately after being deposited.

Examples of silicon mobility inhibitors include oxygen-containing chemical species, for example oxidizing species such as oxygen (O₂) and oxygen-containing compounds, including NO, N₂O, NO₂, CO₂, H₂O, and alcohols. In some embodiments, the mobility inhibitor may be a semiconductor dopant such as PH₃, AsH₃, and SbH₃. In some embodiments, the mobility inhibitor may be a nitriding species, e.g., NH₃. In some embodiments, combinations of the above noted mobility inhibitors may be utilized.

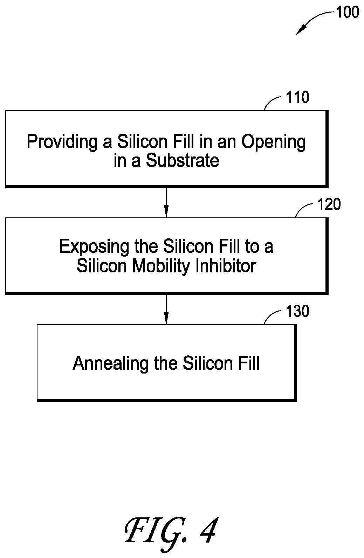

With reference now to the drawings, Figure 4 is a flowchart illustrating a method of reducing voids or seams in a silicon-filled opening. The method 100 includes providing 110 a silicon fill in an opening in a substrate, exposing 120 that silicon fill to a silicon mobility inhibitor, and annealing 130 the silicon fill by subjecting the substrate to an anneal. The anneal may reduce or eliminate voids in the silicon fill. In some embodiments where the silicon fill is amorphous silicon, the anneal may both reduce or eliminate voids in the silicon fill, and also crystallize the silicon fill. It will be appreciated that the opening may be part of a semiconductor substrate such as a silicon wafer. As an example, the substrate may include a layer of material, e.g., a dielectric layer, in which the opening is disposed. In some embodiments, the opening may be an elongated trench. In some embodiments, the opening may have a width of about 100 nm or less (e.g., about 100 nm to about 5 nm), about 50 nm or less (e.g., about 50 nm to about 5 nm), or about 20 nm or less (e.g., about 20 nm to about 8 nm).

With continued reference to Figure 4, providing 110 may simply include receiving a substrate, having openings filled with silicon, for subsequent process blocks 120 and 130. In some other embodiments, providing 110 the opening filled with silicon may include depositing silicon into the opening. For example, a silicon film may be deposited and grown in the opening. In some embodiments, the deposited film may be an as-deposited polysilicon film. Preferably, the polysilicon film is not doped with a surface mobility inhibitor, such as an n-type dopant (including, phosphorus, arsenic or antimony).

In some other embodiments, the silicon film is deposited under conditions that form an amorphous silicon film. For example, the deposition temperature may be sufficiently low that the silicon film grows in the amorphous state. In some embodiments, the deposition temperature is about 550°C or less (e.g., about 550°C to about 480°C), about 530°C or less (e.g., about 530°C to about 485°C), or about 510 °C or less (e.g., about 510°C to about 490°C). Such amorphous silicon films may be deposited with higher step coverage than as-deposited, polycrystalline silicon films, thereby providing smaller voids and facilitating a faster void removal in later blocks 120 and 130. An example of a process for the deposition of the amorphous silicon film has the following conditions:

| | |
|---|---|
| Silicon source: | SiH₄ |
| SiH₄ flow rate: | 660 sccm |
| Pressure: | 500 mTorr |
| Temperature: | 520 °C |

As evident from the above, the amorphous silicon film does not contain a surface mobility inhibitor.

In addition to SiH₄, other non-limiting examples of silicon sources or precursors for depositing the silicon film in the opening include silanes generally, such as disilane, trisilane, or chlorosilanes.

With continued reference to Figure 4, in some embodiments, providing 110 can include providing a silicon fill that incorporates a mobility inhibitor, for example, an electrical dopant such as phosphorus or arsenic. It has been found, however, that simply filling an opening with doped silicon does not allow successful healing of voids in the silicon fill. For example, it has been found that voids in a phosphorus-doped silicon fill are not healed after being annealed (such as an anneal in a subsequent block 130, discussed below). Without being limited by theory, the phosphorus present in the doped fill and on the surfaces of the voids is believed to cause such an inhibition of surface diffusion of the silicon atoms that insufficient rearrangement takes place and healing of the voids is not successfully accomplished.

In some embodiments, providing 110 includes filling the opening with a plurality of layers of material, with the final layer filling the opening being an amorphous silicon layer. For example, the opening may be partially filled with a silicon layer, such as an amorphous silicon layer what contains a mobility inhibitor, the layer having a thickness that is insufficient to completely fill an entire volume of the trench, leaving open an upper portion of the trench near the top of the trench in some embodiments. In some embodiments, the mobility inhibitor is an electrical dopant, such as phosphorus or arsenic. The amorphous silicon layer may be doped by various methods, including, for example, as-deposited doping. The trench is subsequently filled with an undoped amorphous silicon layer such that the trench is filled in and the top of the trench is closed. In some embodiments, the undoped amorphous silicon film has a thickness of about 5 nm or more, or 10 nm or more, which can facilitate having a sufficient quantity of material to rearrange and heal voids in the filled opening, during a subsequent anneal, as discussed herein.

It will be appreciated that silicon film deposited into the opening will fill the opening by growing on the sides and bottoms of the opening. The growth may be uneven and voids are formed, e.g., along the centerline of the opening where films growing on opposing sides of the opening converge. For example, without being limited by theory, opposing portions of the film at upper portions of the opening, near the mouth of the opening, may converge first. This may block off further deposition in lower portions of the opening, thereby causing voids to form in the silicon fill. Thus, the filled opening may be closed at its mouth by the silicon film, but have voids in its interior.

With continued reference to Figure 4, these voids may be eliminated or reduced in size by exposing 120 the silicon fill to a silicon mobility inhibitor and a subsequent anneal 130. It will be appreciated that the silicon mobility inhibitor is a chemical species that interacts with the exposed surface of the silicon fill to stabilize or limit the movement of silicon atoms on that surface. In some embodiments, the silicon mobility inhibitor maintains the roughness of the surface at substantially the same level after the anneal 130 as before that anneal. For example, the surface roughness after the anneal 130 may be within about 10 Å, within about 5 Å, or within about 3 Å of the surface roughness before the anneal 130. Non-limiting examples of silicon mobility inhibitors include oxygen containing species including oxidizing species such as oxygen (O₂) and oxygen-containing compounds, such as NO, N₂O, NO₂, CO₂, H₂O, and alcohols; nitriding species such as NH₃, and semiconductor dopants such as PH₃ and AsH₃. In some embodiments, combinations of oxygen-containing chemical species, nitriding species, and/or semiconductor dopants may be utilized.

In some embodiments, exposing 120 the silicon fill to the silicon mobility inhibitor may include introducing the silicon mobility inhibitor into a process chamber containing the substrate with the silicon fill. For example, the silicon mobility inhibitor may be flowed into the process chamber as a gas. In some embodiments, the process chamber is the same chamber in which the silicon fill was deposited. In some other embodiments, the substrate is removed from the deposition chamber for exposure to the silicon mobility inhibitor. For example, exposing 120 the silicon fill to the silicon mobility inhibitor may include exposing the silicon fill to the ambient air during transport from the deposition chamber to an anneal chamber for annealing 130 the silicon fill. In some embodiments, the deposition and anneal are performed in the same process chamber and exposure to the silicon mobility inhibitor may be accomplished by unloading the substrate to expose it to air and then reloading the substrate into the process chamber. In some embodiments, depositing the silicon fill, exposing the silicon fill to the silicon mobility inhibitor, and annealing the silicon fill are all performed in the same process chamber without unloading the substrates from the process chamber in between any of these depositing, exposing, and unloading steps.

In some embodiments, the exposure to the silicon mobility inhibitor is performed at a temperature that is lower than a temperature at which the silicon atoms at the surface of the silicon fill become mobile and rearrange. As noted herein, annealing the silicon fill without exposure to the silicon mobility inhibitor can increase the roughness of the deposited silicon. To guard against such roughening, in some embodiments, the substrate is not heated above 575°C until after exposure to the mobility inhibitor. In an embodiment, the exposure is performed at least partly during heating of the substrate from the deposition temperature to the anneal temperature, provided that the exposure starts at a temperature lower than 575°C.

It will be appreciated that the duration of the exposure is sufficient for the mobility inhibitor to interact with the surface of the silicon fill to prevent roughening of that surface. In some embodiments, the exposure occurs for a duration of about 1 minute or more. In some embodiments, a thin layer (e.g., a monolayer or less) of the mobility inhibitor is deposited by the exposure.

With continued reference to Figure 4, the silicon fill is annealed at block 130 after being exposed at block 120 to the silicon mobility inhibitor. In some embodiments, the substrate may be transported to a dedicated anneal chamber to perform the anneal. In some other embodiments, the anneal may be performed in the same chamber in which the silicon fill was deposited.

The anneal temperature is generally higher than the deposition temperature and causes silicon atoms in the silicon fill to move, thereby eliminating or reducing the sizes of voids in the silicon fill. In some embodiments, the anneal temperature is about 580°C or higher (e.g., including about 580°C to about 900°C), about 600°C or higher (e.g., including about 600°C to about 850°C), or about 700°C or higher (e.g., including about 700°C to about 800°C). In some embodiments, the duration of the anneal is about 30 minutes or more, or about 60 minutes or more. Advantageously, voids in the silicon fill are not observable or made nearly undetectable by visual inspection after the anneal, while the surface of the deposited silicon remains substantially as smooth as it was before the anneal. In addition, the anneal can advantageously crystallize the amorphous silicon.

### Examples

Various Figures discussed below document experiments for forming silicon-filled openings with no or very small voids. The deposition and anneal processes were performed in an A412™ vertical furnace available from ASM International N.V. of Almere, the Netherlands. The furnace has a process chamber that can accommodate a load of 150 semiconductor substrates, or wafers, having a diameter of 300 mm, with the substrates held in a wafer boat.

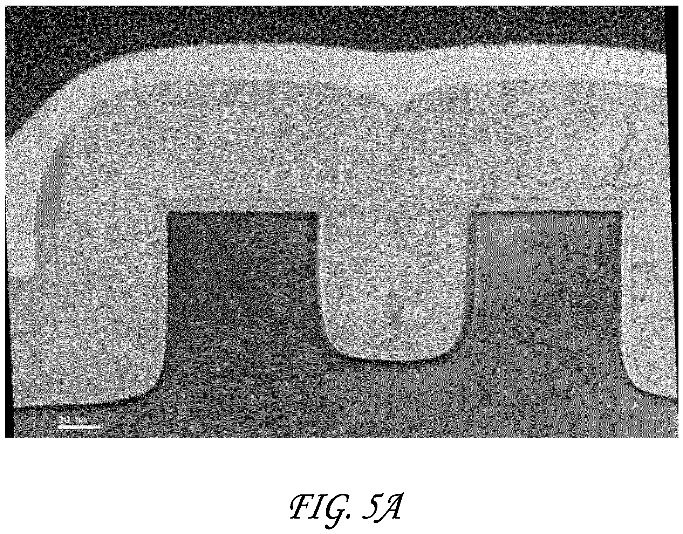

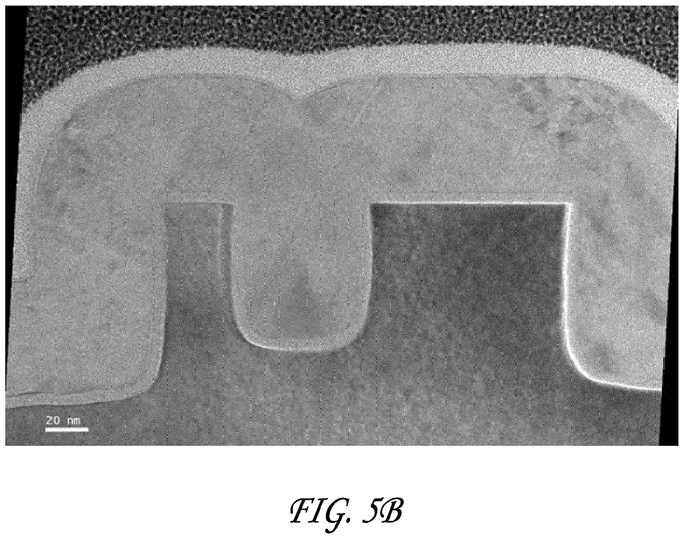

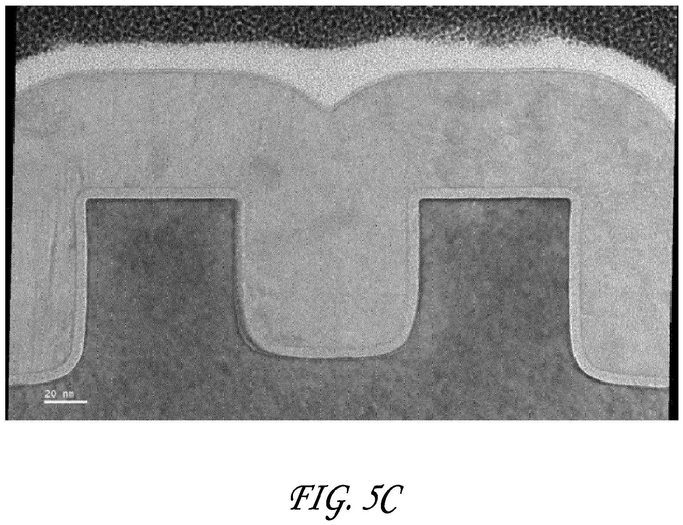

Figures 5A, 5B, and 5C show, respectively, TEM cross-sections of openings filled with an amorphous silicon film, after being exposed to oxygen and annealed at atmospheric pressure at A) 600°C, for 240 minutes; B) 700°C, for 120 minutes; and C) 800°C, for 60 minutes. The amorphous silicon film was deposited into trenches having widths of about 40 nm to about 80 nm under the following conditions:

| | |
|---|---|
| Silicon source: | SiH₄ |
| SiH₄ flow rate: | 660 sccm |
| Pressure: | 500 mTorr |
| Temperature: | 520 °C |

After the deposition, as noted above, the substrates were unloaded from the deposition furnace and transported to an anneal furnace where they were annealed in N₂ at atmospheric pressure at the following conditions: A) 600°C, 240 min; B) 700°C, 120 min; and C) 800°C, 60 min. The substrates are exposed to oxygen in the atmospheric air during transport from the deposition furnace to the anneal furnace. Desirably, no voids or seams are visible in the silicon fill in any of Figures 5A, 5B, or 5C.

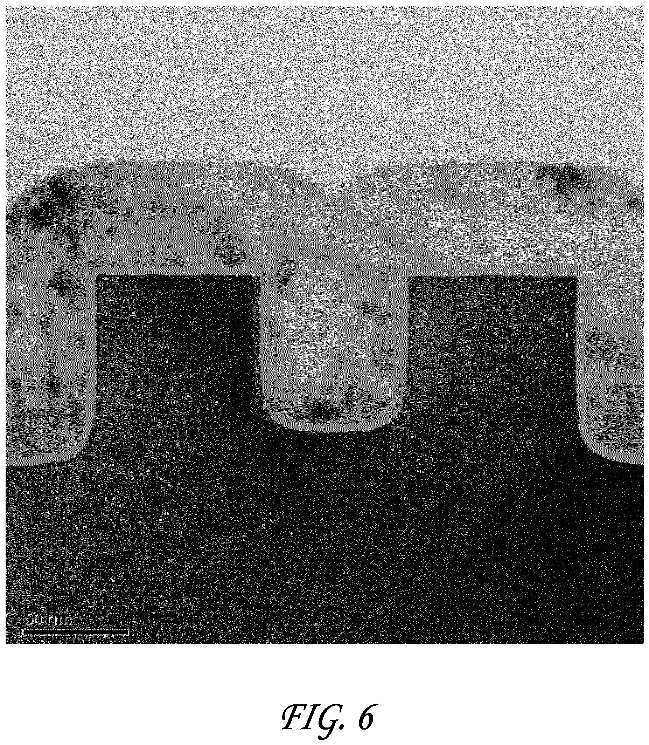

Figure 6 shows a TEM cross-section of an opening filled with an amorphous silicon film, after being exposed to oxygen and annealed at 500 mTorr and 600°C for 240 minutes. The silicon film was deposited as noted above with respect to Figures 5A, 5B, and 5C. After depositing the silicon film, the substrates are exposed to oxygen by being unloaded from the deposition furnace. The substrates were unloaded into an N₂ mini-environment with about 10 ppm O₂ and then re-inserted in the deposition furnace again to perform the anneal. The anneal was performed at 600°C for 240 min and at a pressure of 1 Torr. The surface of the deposited films remained smooth and the voids or seams that were present were healed and could not be observed anymore. Thus, it was found that the residual oxygen concentration of about 10 ppm or more in the N₂ mini-environment was sufficient to stabilize the surface of the silicon fill. In another experiment, with all of the other conditions being the same, the anneal was performed at a pressure of 150 Torr and the same result was observed.

Unloading substrates from the deposition chamber may be time consuming. In some experiments, the amorphous silicon film was deposited and annealed under conditions similar to those above. However, substrates were not removed from the deposition chamber during the exposure to a mobility inhibitor. Rather, the amorphous silicon film was exposed to PH₃ (1% in N₂ or H₂), which was flowed into the deposition chamber at a flow rate of 66 sccm, with the deposition pressure at 200 mTorr and deposition temperature at 520°C. The silicon film was exposed to the PH₃ for 10 minutes. It was found that this exposure was effective in substantially completely suppressing surface roughening during a subsequent anneal, while also eliminating voids in the silicon fill. It is contemplated that similar results may be achieved by exposing the amorphous silicon film *in-situ* (in the deposition chamber) to a flow of oxygen for, *e.g.,* 1 minute or more.

## Claims

1. A method for semiconductor processing, comprising:
depositing an amorphous silicon film onto a substrate at a deposition temperature in a deposition chamber, the substrate having a trench and the amorphous silicon film having a thickness sufficient to fill the trench, wherein depositing the amorphous silicon film has a pinching behavior and forms voids in a closed volume;
exposing an exposed surface of the amorphous silicon film to an oxidizing gas, a nitriding gas, or an n-type dopant gas at a temperature of 575°C or below while the pinching behaviour of depositing the amorphous silicon film prevents or limits movement of the oxidizing gas, the nitriding gas, or the n-type dopant gas into the voids;
subsequently heating the substrate to an anneal temperature; and
maintaining the substrate at the anneal temperature to crystallize the amorphous silicon film in the trench.

2. The method of Claim 1, wherein exposing the exposed surface of the amorphous silicon film to the n-type dopant comprises exposing the exposed surface of the amorphous silicon film to a phosphorus-containing gas, an arsenic-containing gas, or an antimony-containing gas.

3. The method of Claim 1, further comprising, before depositing the amorphous silicon film:
forming a doped silicon film, preferably doped with arsenic or phosphorous, in the trench, the doped silicon film occupying less than an entire volume of the trench,
wherein depositing the amorphous silicon film comprises depositing the amorphous silicon film in a remaining open portion of the volume, and wherein the amorphous silicon film is undoped, wherein the amorphous silicon film preferably has a thickness of 5 nm or more.

4. The method of Claim 1, wherein maintaining the substrate at the anneal temperature is performed for a duration of 30 minutes or more.

5. The method of Claim 1, wherein the anneal temperature is 580°C or higher, preferably 600°C or higher.

6. The method of Claim 1, wherein the deposition temperature is 550°C or lower.

7. The method of Claim 1, wherein exposing the amorphous silicon film to the oxidizing gas comprises unloading the substrate from the deposition chamber, thereby exposing the substrate to an ambient atmosphere outside the deposition chamber, and preferably further comprises transporting the substrate from the deposition chamber to an anneal chamber for heating the substrate to the anneal temperature, the method optionally further comprising reloading the substrate into the deposition chamber, wherein heating the substrate to the anneal temperature and maintaining the substrate at the anneal temperature is performed in the deposition chamber.

8. The method of Claim 1, wherein exposing the amorphous silicon film to the oxidizing gas, the nitriding gas, or the n-type dopant gas comprises flowing the oxidizing gas, the nitriding gas, or the n-type dopant gas into the deposition chamber.

9. The method of claim 1, wherein exposing the amorphous silicon film, heating the substrate to the anneal temperature, and maintaining the substrate at the anneal temperature is performed in the deposition chamber without unloading the substrates from the deposition chamber between any of depositing the amorphous silicon film and exposing the amorphous silicon film, exposing the amorphous silicon film and heating the substrate, and heating the substrate and maintaining the substrate at the anneal temperature.

10. The method of Claim 1, wherein exposing the amorphous silicon film to the oxidizing gas is performed for 1 minute or more.

11. The method of Claim 1, wherein the deposition chamber is a process chamber of a batch furnace.

12. The method of Claim 1, wherein maintaining the substrate at the anneal temperature converts the amorphous silicon film in a polysilicon film.

13. The method of Claim 1, wherein the oxidizing gas is selected from the group consisting of O₂, NO, N₂O, NO₂, CO₂, H₂O, alcohols, and combinations thereof.

14. The method of Claim 1, wherein heating the substrate to an anneal temperature substantially eliminates the voids.

## Patentansprüche

1. Ein Verfahren zur Halbleiterverarbeitung umfassend:
Abscheiden eines amorphen Siliciumfilms auf einem Substrat bei einer Abscheidungstemperatur in einer Abscheidungskammer, wobei das Substrat eine Furche aufweist und der amorphe Siliciumfilm eine Dicke aufweist, die ausreicht, die Furche zu füllen, wobei
das Abscheiden des amorphen Siliciumfilms ein einklemmendes Verhalten aufweist und Hohlräume in einem geschlossenen Volumen bildet,
Aussetzen einer exponierten Oberfläche des amorphen Siliciumfilms gegenüber einem oxidierenden Gas, einem nitrierenden Gas oder einem Gas eines Dotierungsmittels vom n-Typ bei einer Temperatur von 575 °C oder weniger, während das einklemmende Verhalten des Abscheidens des amorphen Siliciumfilms eine Bewegung des oxidierenden Gases, des nitrierenden Gases oder des Gases eines Dotierungsmittels vom n-Typ in die Hohlräume verhindert oder begrenzt,
nachfolgendes Erhitzen des Substrats auf eine Glühtemperatur, und
Halten des Substrats bei der Glühtemperatur, um den amorphen Siliciumfilm in der Furche zu kristallisieren.

2. Das Verfahren des Anspruchs 1, wobei das Aussetzen der exponierten Oberfläche des amorphen Siliciumfilms gegenüber dem Dotierungsmittel vom n-Typ ein Aussetzen der exponierten Oberfläche des amorphen Siliciumfilms gegenüber einem phosphorhaltigen Gas, einem arsenhaltigen Gas oder einem antimonhaltigen Gas umfasst.

3. Das Verfahren des Anspruchs 1, des Weiteren umfassend, vor dem Abscheiden des amorphen Siliciumfilms:
Ausbilden eines dotierten Siliciumfilms, vorzugsweise dotiert mit Arsen oder Phosphor, in der Furche, wobei der dotierte Siliciumfilm weniger als ein gesamtes Volumen der Furche belegt,
wobei das Abscheiden des amorphen Siliciumfilms ein Abscheiden des amorphen Siliciumfilms in einen verbleibenden offenen Teil des Volumens umfasst, und wobei der amorphe Siliciumfilm undotiert ist, wobei der amorphe Siliciumfilm vorzugsweise eine Dicke von 5 nm oder mehr aufweist.

4. Das Verfahren des Anspruchs 1, wobei das Halten des Substrats bei der Glühtemperatur für eine Dauer von 30 Minuten oder länger ausgeführt wird.

5. Das Verfahren des Anspruchs 1, wobei die Glühtemperatur 580 °C oder mehr, vorzugsweise 600 °C oder mehr beträgt.

6. Das Verfahren des Anspruchs 1, wobei die Abscheidungstemperatur 550 °C oder weniger beträgt.

7. Das Verfahren des Anspruchs 1, wobei das Aussetzen des amorphen Siliciumfilms gegenüber dem oxidierenden Gas ein Entnehmen des Substrats aus der Abscheidungskammer umfasst, um dadurch das Substrat einer Umgebungsatmosphäre außerhalb der Abscheidungskammer auszusetzen, und vorzugsweise des Weiteren ein Transportieren des Substrats von der Abscheidungskammer zu einer Glühkammer zum Erhitzen des Substrats auf die Glühtemperatur umfasst, das Verfahren wahlweise des Weiteren umfassend ein Wiedereineinbringen des Substrats in die Abscheidungskammer, wobei das Erhitzen des Substrats auf die Glühtemperatur und Halten des Substrats bei der Glühtemperatur in der Abscheidungskammer ausgeführt wird.

8. Das Verfahren des Anspruchs 1, wobei das Aussetzen des amorphen Siliciumfilms gegenüber dem oxidierenden Gas, dem nitrierenden Gas oder dem Gas eines Dotierungsmittels vom n-Typ ein Fließen des oxidierenden Gases, des nitrierenden Gases oder des Gases eines Dotierungsmittels vom n-Typ in die Abscheidungskammer umfasst.

9. Das Verfahren des Anspruchs 1, wobei das Aussetzen des amorphen Siliciumfilms, Erhitzen des Substrats auf eine Glühtemperatur und Halten des Substrats bei der Glühtemperatur in der Abscheidungskammer ohne Entnehmen der Substrate aus der Abscheidungskammer zwischen einem oder jeglichen von Abscheiden des amorphen Siliciumfilms und Aussetzen des amorphen Siliciumfilms, Aussetzen des amorphen Siliciumfilms und Erhitzen des Substrats, und Erhitzen des Substrats und Halten des Substrats bei der Glühtemperatur durchgeführt wird.

10. Das Verfahren des Anspruchs 1, wobei das Aussetzen des amorphen Siliciumfilms gegenüber dem oxidierenden Gas für 1 Minute oder länger ausgeführt wird.

11. Das Verfahren des Anspruchs 1, wobei die Abscheidungskammer eine Prozesskammer eines Kammerofens ist.

12. Das Verfahren des Anspruchs 1, wobei das Halten des Substrats bei der Glühtemperatur den amorphen Siliciumfilm in einen Polysiliciumfilm umwandelt.

13. Das Verfahren des Anspruchs 1, wobei das oxidierende Gas aus der Gruppe bestehend aus O₂, NO, N₂O, NO₂, CO₂, H₂O, Alkoholen und Kombinationen derselben ausgewählt ist.

14. Das Verfahren des Anspruchs 1, wobei das Erhitzen des Substrats auf eine Glühtemperatur die Hohlräume im Wesentlichen entfernt.

## Revendications

1. Procédé de traitement de semi-conducteur comprenant les étapes suivantes :
déposer un film de silicium amorphe sur un substrat à une température de dépôt dans une chambre de dépôt, le substrat comportant une tranchée et le film de silicium amorphe ayant une épaisseur suffisante pour remplir la tranchée, dans lequel le dépôt du film de silicium amorphe a un comportement de pincement et forme des vides dans un volume fermé ;
exposer une surface exposée du film de silicium amorphe à un gaz oxydant, un gaz nitrurant ou un gaz dopant de type N à une température de 575 °C ou inférieure tandis que le comportement de pincement du dépôt du film de silicium amorphe empêche ou limite le mouvement du gaz oxydant, du gaz nitrurant ou du gaz dopant de type N dans les vides ;
chauffer de façon consécutive le substrat jusqu'à une température de recuit ; et
maintenir le substrat à la température de recuit pour faire cristalliser le film de silicium amorphe dans la tranchée.

2. Procédé selon la revendication 1, dans lequel l'exposition de la surface exposée du film de silicium amorphe au dopant de type N comprend le fait d'exposer la surface exposée du film de silicium amorphe à un gaz contenant du phosphore, un gaz contenant de l'arsenic ou un gaz contenant de l'antimoine.

3. Procédé selon la revendication 1, comprenant en outre, avant le dépôt du film de silicium amorphe, l'étape suivante :
former un film de silicium dopé, de préférence dopé à l'arsenic ou au phosphore, dans la tranchée, le film de silicium dopé occupant moins qu'un volume entier de la tranchée,
dans lequel le dépôt du film de silicium amorphe comprend le fait de déposer le film de silicium amorphe dans une partie ouverte restante du volume, et dans lequel le film de silicium amorphe est non dopé, le film de silicium amorphe ayant de préférence une épaisseur de 5 nm ou plus.

4. Procédé selon la revendication 1, dans lequel le maintien du substrat à la température de recuit est exécuté pendant une durée de 30 minutes ou plus.

5. Procédé selon la revendication 1, dans lequel la température de recuit est égale à 580 °C ou plus, de préférence 600 °C ou plus.

6. Procédé selon la revendication 1, dans lequel la température de dépôt est égale à 550 °C ou moins.

7. Procédé selon la revendication 1, dans lequel l'exposition du film de silicium amorphe au gaz oxydant comprend le fait de décharger le substrat de la chambre de dépôt, et d'exposer ainsi le substrat à une atmosphère ambiante à l'extérieur de la chambre de dépôt, et comprend de préférence en outre le fait de transporter le substrat de la chambre de dépôt à une chambre de recuit pour chauffer le substrat à la température de recuit, le procédé comprenant en outre en option le fait de charger de nouveau le substrat dans la chambre de dépôt, dans lequel le chauffage du substrat jusqu'à la température de recuit et le maintien du substrat à la température de recuit est réalisé dans la chambre de dépôt.

8. Procédé selon la revendication 1, dans lequel l'exposition du film de silicium amorphe au gaz oxydant, au gaz nitrurant ou au gaz dopant de type N comprend le fait de faire entrer le gaz oxydant, le gaz nitrurant ou le gaz dopant de type N dans la chambre de dépôt.

9. Procédé selon la revendication 1, dans lequel l'exposition du film de silicium amorphe, le chauffage du substrat jusqu'à la température de recuit et le maintien du substrat à la température de recuit est réalisé dans la chambre de dépôt sans décharger les substrats de la chambre de dépôt entre l'une quelconque des étapes de dépôt du film de silicium amorphe et d'exposition du film de silicium amorphe, d'exposition du film de silicium amorphe et de chauffage du substrat, et de chauffage du substrat et de maintien du substrat à la température de recuit.

10. Procédé selon la revendication 1, dans lequel l'exposition du film de silicium amorphe au gaz oxydant est réalisée pendant 1 minute ou plus.

11. Procédé selon la revendication 1, dans lequel la chambre de dépôt est une chambre de traitement d'un four discontinu.

12. Procédé selon la revendication 1, dans lequel le maintien du substrat à la température de recuit convertit le film de silicium amorphe en un film de polysilicium.

13. Procédé selon la revendication 1, dans lequel le gaz oxydant est choisi dans le groupe comprenant O₂, NO, N₂O, NO₂, CO₂, H₂O, les alcools, et leurs combinaisons.

14. Procédé selon la revendication 1, dans lequel le chauffage du substrat jusqu'à une température de recuit élimine substantiellement les vides.
